(19) Europäisches Patentamt

European Patent Office

Office européen des brevets

(11) EP 0 893 915 A2

## EUROPEAN PATENT APPLICATION

(12)

(43) Date of publication:
27.01.1999 Bulletin 1999/04

(51) Int. Cl.⁶: **H04N 5/335**, H04N 5/225, H04N 3/15

(21) Application number: 98201979.6

(22) Date of filing: 12.06.1998

(84) Designated Contracting States:
AT BE CH CY DE DK ES FI FR GB GR IE IT LI LU MC NL PT SE
Designated Extension States:
AL LT LV MK RO SI

(30) Priority: 25.06.1997 US 882446

(71) Applicant: EASTMAN KODAK COMPANY
Rochester, New York 14650 (US)

(72) Inventor: Meyers, Mark Marshall
Rochester, New York 14650-2201 (US)

(74) Representative:
Lewandowsky, Klaus, Dipl.-Ing. et al
Kodak Aktiengesellschaft,
Patentabteilung
70323 Stuttgart (DE)

(54) **Compact image sensor with display integrally attached**

(57) A compact digital camera utilizing an array of lenslets, each viewing a different segment of the available field of view and incorporating local signal processing circuitry located adjacent sub arrays of photosensors is connected to a display with connecting holes etched through a supporting substrate in order to allow direct integral contact to corresponding pixels of the display. By using direct contact to the display, the signal processing for controlling the brightness of each individual display pixel can be incorporated on the compact digital camera, thereby eliminating the need to send data to an external circuit for processing and display.

FIG. I

EP 0 893 915 A2

## Description

## CROSS-REFERENCE TO RELATED APPLICATIONS

The present application is related to U.S. Application Serial Number 08/699,306, filed August 19, 1996, tilled "Compact Image Capture Device;" U.S. Application Serial Number 08/743,653, filed November 04, 1996, titled "Compact Digital Camera With Segmented Fields of View;" and U.S. Application Serial Number 08/720,282, filed September 26, 1996, titled "Compact Image Capture Device With Local Image Storage," all by Mark M. Meyers.

## FIELD OF THE INVENTION

The invention is related to the field of digital cameras, and more specifically to compact digital cameras incorporating a display to allow the review of digital images which have been captured and stored in the camera's memory.

## BACKGROUND OF THE INVENTION

Lenslet arrays have been used to concentrate light imaged on a photosensor plane by a photographic objective into smaller areas to allow more of the incident light to fall on the photosensitive area of the photosensor array and less on the insensitive areas between the pixels. This has been described in papers such as "Visible Array Detectors" by Timothy J. Tredwell, from HANDBOOK OF OPTICS, VOL. 1, FUNDAMENTALS, TECHNIQUES, & DESIGN, SECOND EDITION, SECOND EDITION, Chapter 22, pp. 32-34. These lenslet arrays are centered directly above the corresponding photosensor and are not designed to look at different portions of the field of view independently. Rather, they concentrate the light from an existing image, formed by the photographic objective, into the pixel aperture.

In U.S. Patent No. 4,994,664, enticed, "Optically Coupled Focal Plane Arrays Using Lenslets And Multiplexers" by Veldkamp, an array of diffractive lenslets is used to concentrate collimated fight coming from one direction onto an array of photosensors in order to allow for location of amplifying circuitry in areas between photosensor sites. This device is not related to the current invention since it is not looking over a field of view suitable for a camera, ether it stares straight ahead.

In U.S. Patent No. 5,233,174, entitled, "Wavefront Sensor Having A Lenslet Array As A Null Corrector" by Zmek, an array of diffractive lenslets with decenters which are adjusted to eliminate the local monochromatic wavefront tilt from a specific optic under test in an interferometric or Hartman type test. A Hartman test is used to certify the surface quality of various optics. If the optics under test falls within the acceptance criteria, the wavefront incident on the sensor array will form centered light spots on predetermined pixels. If the wavefront is other than the desired wavefront, the light spots will be incident on different pixel elements. That invention is not applicable to the current invention since the centered lenslets are not looking at regularly spaced sections of a predetermined field of view. It is also not applicable to white light applications due to the chromatic aberrations of the diffractive lenslets.

U.S. Patent No. 5,340,978, entitled, "Image-Sensing Display With LCD Display Panel And Photosensitive Element Array" Rostoker et al., briefly describes an array of decentered lenses which form an image of a segment of the field of view. These lenses are widely separated and do not include a workable method for limiting a field of view seen by a group of pixels. Light from outside the desired field of view can be incident on the photosensor by scattering off the walls of a spacer clement or by reflection and reimaging of light within the array substrate. The wide separation of the lenslets in the array limits the amount of light which can be gathered and focused on the image sensor. The use of the widely separated pixels greatly increases the cost of the sensor since there will be fewer sensor arrays fabricated on a given size substrate or wafer. In addition, the larger sensor array size causes a decreased yield of finished sensor arrays for a given manufacturing process.

Rostoker does not envision the use of diffractive/refractive hybrids for achromatization. The patent assumes the use of an array of uniformly shaped lenslets while in the present invention the utility of varying the surface profile of the lenslets as a function of their radial position in the lenslet array allows for a higher level of aberration correction. Also, in the current invention the lenses will be abutted to each other and an opaque baffle will be placed over the photosensor to limit the field of view of each pixel. The referenced patent uses one lenslet per group of three color pixels. In the current invention it is shown to be advantageous to form a small array of pixels for each lenslet if the focal length of each lenslet is adjusted appropriately or to use one lenslet per group of three colored pixels.

The invention disclosed in U.S. Patent No. 5,471,515, to Fossum, et. al., entitled "Active Pixel Sensor with Intra-Pixel Charge Transfer," converts the photogenerated charge, stored under the photogate of a semiconductor photosensor into a voltage by transferring the charge to a sense node (typically a capacitor) located within the active pixel unit cell. Fossum then utilizes dual sample correlated double sampling of the voltage based signal to reduce signal noise and eliminate the effect of dark current and flicker noise from the photosensor. The Fossum invention does not however allow for an increase in the overall sensitivity of the photosensor (CCD detector) elements through the use of amplification. Fossum is not concerned with utilization of an array optic to form an image of different segments of a field of view, although the patent does disclose the use of a lens array for concentrating light on the active pixel. The present invention provides for the digitization and storage of the digital image data at each photosensor site, which Fossum did not teach.

In U.S. Patent No. 5,004,901, enticed "Current Mirror Amplifier for use in an Optical Data Medium Driving Apparatus and Servo Circuit" to Yoshimoto, et. al., photogenerated current from an optical disk tracking and read sensor is amplified in feed steps by a switchable series of current mirrors, where the current mirrors achieve current multiplication through the use of output stages that incorporate either multiple output transistors with the bases of the output transistors connected in parallel or by the use of output transistors with emitter areas that are integral multiples of the emitter areas of the input side transistor.

## SUMMARY OF THE INVENTION

The present invention is directed to overcoming one or more of the problems set forth above. Briefly summarized, according to one aspect of the present invention, a compact image capture and display device, comprising: an array of spaced apart radiation sensors for providing output signals that are a function of the amount of incident radiation from an image onto each radiation sensor; array electronics dispersed in the spaces between the spaced apart radiation sensors for receiving and processing the provided output signals to facilitate image capture; a lens array positioned so as to focus the radiation of an image to be captured onto said radiation sensors; and a display connected in close proximity to said array electronics to receive the processed output signals from said array electronics and to display the image captured by said radiation sensors.

## ADVANTAGEOUS EFFECT OF THE INVENTION

The present invention has the following advantages: The compact image capture device has greater utility and compactness since it incorporates a flat, emissive display to allow the review of images stored in the camera or to display the image currently seen by the compact image capture device. Additionally, it incorporates an array optic objective, digital capture signal processing and display driver electronics on the sensor substrate and is directly bonded to an emissive display.

The use of a CMOS process to fabricate the photosensors and the associated signal processing electronics allows the use of a single voltage supply and allows a significant reduction in the overall power consumption of the system.

Due to its highly integrated nature the system is low cost to manufacture and easy to assemble.

These and other aspects, objects, features, and advantages of the present invention will be more clearly understood and appreciated from a review of the following detailed description of the preferred embodiments and appended claims, and by reference to the accompanying drawings wherein like characters indicate like parts.

## BRIEF DESCRIPTION OF THE DRAWINGS

Fig. 1 is a partially cut away perspective view of a compact image sensor with an integral display;
Fig. 1A is an enlarged view of a portion of the image sensor of Fig. 1;
Fig. 2 is a section view taken along the section lines 2-2 shown in Fig. 1;
Fig. 2A is an enlarged view of a portion of the image sensor and integral display of Fig. 2;
Fig. 3 is a block schematic diagram of a first preferred arrangement of the present invention;
Fig. 4 is a partially cut away perspective view of a second embodiment of the present invention using a plurality of red, green, and blue sensors under each lenslet of the lens array;
Fig. 4A is an enlarged view of a portion of the second embodiment of the present invention shown in Fig. 4;
Fig. 5 is a section view taken along the section lines 5-5 shown in Fig. 4;
Fig. 6 is a block schematic diagram of a second preferred arrangement of the present invention; and
Fig. 7 is a block diagram with tables indicating the manipulation of sub-images at the pixel level to form an output image corresponding to the original image that the invention has captured.

## DETAILED DESCRIPTION OF THE INVENTION

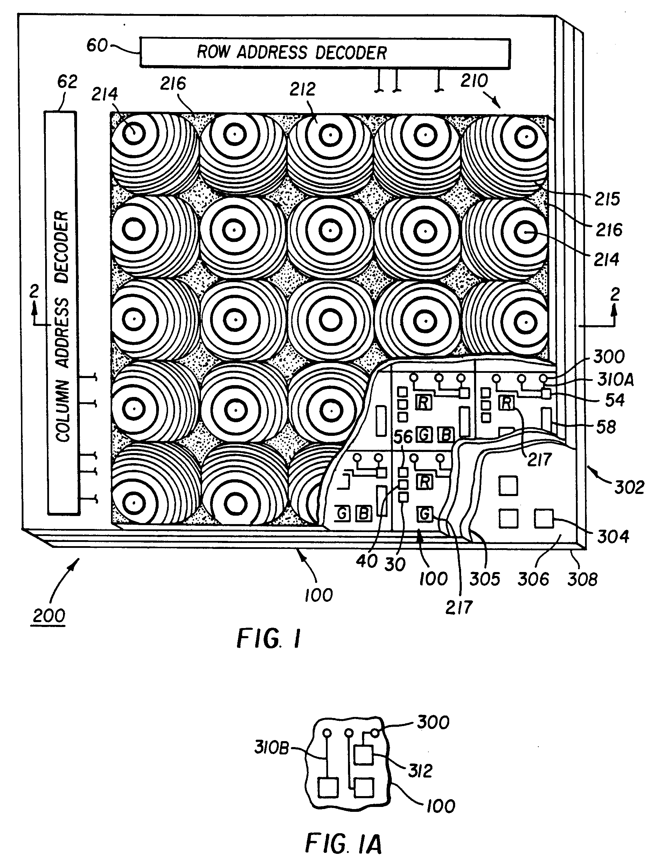

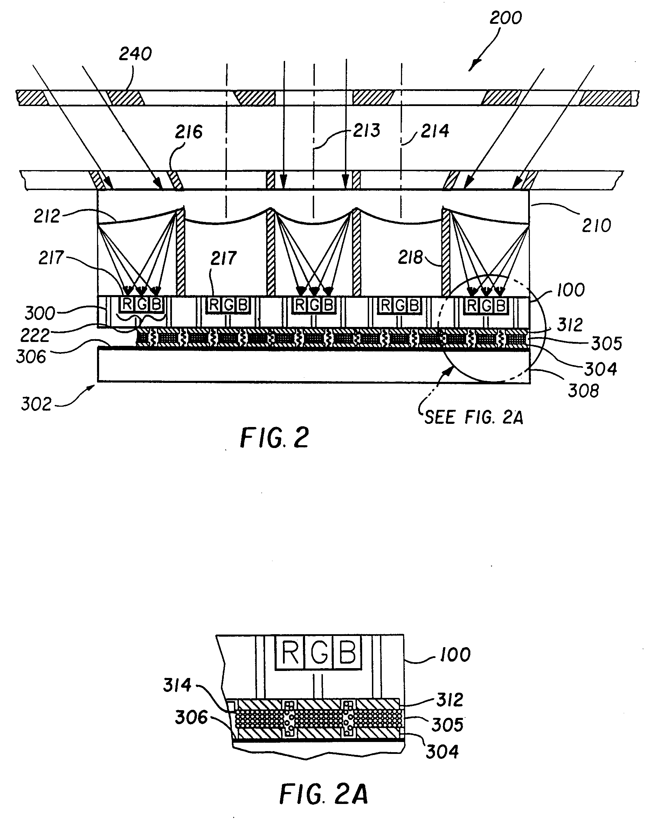

Referring to Figs. 1 and 2, the major components of a compact image capture and display device (digital camera) 200 are a photosensor array 100, a lenslet array 210, and a display 302. The lenslet array 210 is formed with achromatized refractive/diffractive lenslets 212 or refractive lenslets which are centered over photosensor sites (photosensors) 217 formed in the photosensor array 100. The lenslet array 210 replaces the typical single, long focal length multi-element lens that is spaced along one central axis in a camera. To be observed in Fig. 1 is that the center of the mechanical optical axis 214 of each lenslet 212 is displaced relative to the fixed sensor-to-sensor distance as a function of its radial distance from the optical axis 213 of the central lenslet which is at the physical center of the array shown. The circular lines 215, appearing around the mechanical optical axis 214 of each lenslet 212, are topographical lines indicating equal changes in height of the lenslet's surface. An opaque mask 216 covers the areas between the lenslets 212 to prevent light from reaching the photosensor sites 217 other than by being focused by an associated lenslet. The arrays depicted in Figs. 1 and 2 represent only a small portion of the arrays that are used in an actual digital camera A typical implementation consists of 480 x 640 (or more) lenslets 212 with 3 photosensor sites 217 per lenslet, one for each of the primary colors, red, green, and blue. Other configurations of the lenslets may be used such as forming the outer periphery of each lenslet 212 as a square, hexagon, or circle, without detracting from the invention.

In order for the lenslet array 210 to see different fields of view, the optical axis 214 of the lenslets 212 are located at a distance which becomes progressively larger than the center-to-center distance of the pixels generated by the photosensor array 100. For definition purposes a pixel is defined as the resultant image light focused by one lenslet 212 onto an associated one or group of photosensor sites 217. For a monochrome image only one photosensor is needed at one site. For a color image three photosensors are needed at three sites to generate the electrical signals for a pixel. The displacement of the lenslet's optical axis 214 increases radially from the center of the lenslet array. Decentering a lenslet tends to bend rays from off-axis field angles into the center of the lenslet's field of view. By moving the optical axis of the lenslet further out radially with increasing distance from the center of the photosensor array 100, the angular location of an object at the center of the field of view for a given lenslet/photosensor pair originates from increasingly off-axis segments of the total field of view. The photosensor array 100 includes a silicon substrate for the photosensors and the interdispersed electronics: photosensor 20, multiplying current mirror 30, correlated double sampling circuit (CDS) 40, pixel display driver element 54, analog-to-digital converter 56, non-volatile memory 58, data bus 5O, and row and column address decoders 60 and 62, all to be described in more detail later. The electrical signals generated and processed on the top surface of the photosensor array 100 needed for driving the display 302 have to be connected through the silicon substrate.

The lenslet array 210 is located over the photosensor array 100 of photosensor sub arrays 222. Each photosensor sub arrays 222 is located at an associated photosensor site 217. Each group of photosensor sub arrays 222 is formed with red (R), green (G), and blue (B)sensors. The number of photosensor sites 217 corresponds in number to at least the number of lenslets 212 in the lenslet array 210. The lenslet array 210 is maintained a distance apart from the surfaces of the photosensors 222 by spacers 218 that serve the additional function of being light baffles. The opaque masks 216 on the lenslet array 210, combined with a field stop aperture plate 240 limit the field of view of any particular photosensor 222 so that it does not overlap the field of view of its neighbors by a large amount. The aperture plate 240, is positioned approximately O.5 mm to 2.0 mm from the surface of the lenslet array 210. The aperture plate 240 may be a layer of clear glass having a dyed photoresist mask pattern formed on one of it's surfaces.

The center of the apertures in the aperture plate 240 are aligned to the center of the field of view of a corresponding lenslet. The spacing of the mechanical optical centers 214 increases as a function of each lenslet's position radially from the center of the array causing the aperture plate 240 to be slightly larger than the associated lenslet array 210. The combination of the opaque areas 216 with the aperture plate 240 and a given lenslet focal length determines the field of view for a photosensor site 217. The lenslet array 210 can be formed of etched quartz, or as an epoxy replica on a glass substrate or can be injection molded with plastic.

The lenslets 212, combined with the appropriate field stop aperture plate 240, form images of a small segment of the field of view on each photosensor site 217. By forming the lenslets 212 with decentrations of the mechanical optical axis 214, which increase radially across the lenslet array, the angle which the axial ray incident on any particular lenslet makes with the surface normal to the plane of the lenslet array 210 will increase as a function of the particular lenslet's radial position on the array. Therefore, by appropriately forming the decenters of each lenslet each photosensor site 217 will view a different segment of a scene (image). Since each photosensor sub array 222 has its own lenslet there is no need to reinvert the image with a relay lens.

Any camera system, incorporating the present invention, can be extremely compact and flat due to the integration of the above described circuitry which allows for the elimination of support circuit boards which in turn allows for a further decrease in the size of the camera. The camera can work in black and white or in color if three unit pixel subassemblies with color filters are formed at each photosensor site 217 to pass only assigned frequencies of incident radiation. Also shown are through-holes 300 located adjacent to the photosensitive sub arrays 222 which through-holes 300 have been metalized to provide electrical contact to the emissive pixel 304. A transparent indium tin oxide layer 306 is the conductive layer that provides an electrical ground for all the emissive pixels 304. A glass layer 308 provides a transparent rigid support to the display.

The connections to the display are made by etching the through-holes 300 through the silicon substrate of the photosensor array 100 and plated through the holes using Deep Reactive Ion Etching technologies such as those implemented in the STS Systems Multiplex ICP High Density Plasma System or the Oxford Instruments Cryo-RIE unit. These new types of RIE etchers provide the ability to etch holes all the way through a silicon substrate to allow the formation of contacts through to the rear of the substrate.

The conductive through contacts are formed by vapor depositing a metal, such as aluminum or gold, over the top and bottom of the entire silicon substrate. This is accomplished by vapor deposition, sputtering or electroplating the metal onto the silicon substrate. The top side of the metalization is then patterned using lithography to form traces 310A which lead from the pixel display driver element 54, on the top of the silicon substrate, to the plated through-holes 300. Since the metal has been deposited on the top and bottom of the silicon substrate, the through-holes 300 will be filled with a continuous piece of conductive metal which allows contact from the top traces 310A to the bottom metalization layer. In a like manner, referring specifically to Fig. 1A traces 310B are formed from each plated through-hole 300 to a corresponding metal pad 312. Note: Fig. 1A is looking up from the bottom of the photosensor array 100.

The bottom layer is lithographically patterned to form the metal pads 312 over the through-holes 300. The pads have the same (or smaller) area as the emissive pixel 304 on the display 302. In this way the metalization from an individual pixel driver circuit is connected to only one emissive pixel and is isolated from all other circuits and pixels.

The pixel display driver 54 provides voltage signals proportional to the light emitted from the emissive pixels 304. In this fashion pixel display information can be viewed without the need to transmit data to an external display driver or external sensor clocking circuitry. Additionally only one power supply is needed to operate the CMOS based photosensor array and display as opposed to three used with standard CCD. The display 302 is comprised of a number of emissive pixels 304 capable of outputting either white, red, green, or blue light for presenting a Gray scale or color image of the photographic scene being captured or reviewed for capture. These emissive pixels 304 can be electroluminescent materials or organic light emitting diode materials such as those described in U.S. Patents 5,151,629, titled, "Blue Emitting Internal Junction Organic Electroluminescent Device (I)" by VanSlyke, and 5,126,214, titled "Electroluminescent Element," by Tokailin, et al. An indium tin oxide or other transparent conductor 306 is coated onto a glass substrate 308. The display 302 is operated by driving current through the emissive pixel 304 into the indium tin oxide 306 which is electrically grounded.

To attach the display, the emissive pixels 304 are aligned to the metalized pads 312. A anisotropically conductive film 305 is sandwiched between the display 302 and the photosensor array 100 (as shown in Fig. 2 and Fig. 2A). The anisotropic conductive film 305 consists of conductive metal spheres 314 embedded in a polymeric binder. When the film 305 is subjected to pressure and an elevated temperature it will compress the metal spheres 314 into contact with each other in the area between the metalized pad 312 and the emissive pixel 304. The contacting metal spheres 314 will provide a conduction path between the pixel display driver element 54 and the emissive pixel 304. Note: in Fig. 2A the metal spheres 314 are not in contact with each other in the space between the back surface of 100 and the tin oxide layer 306.

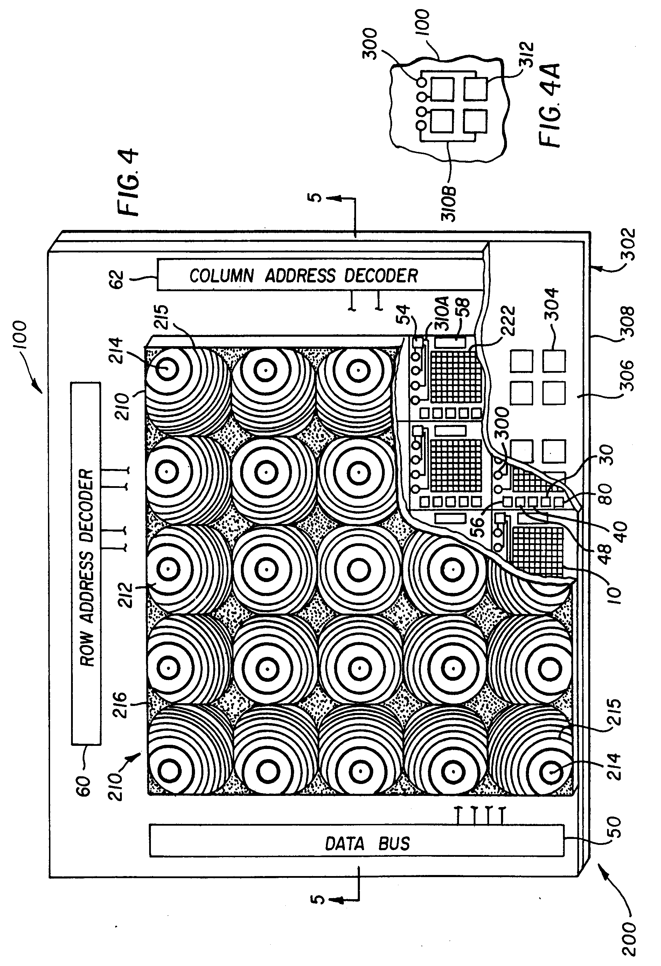

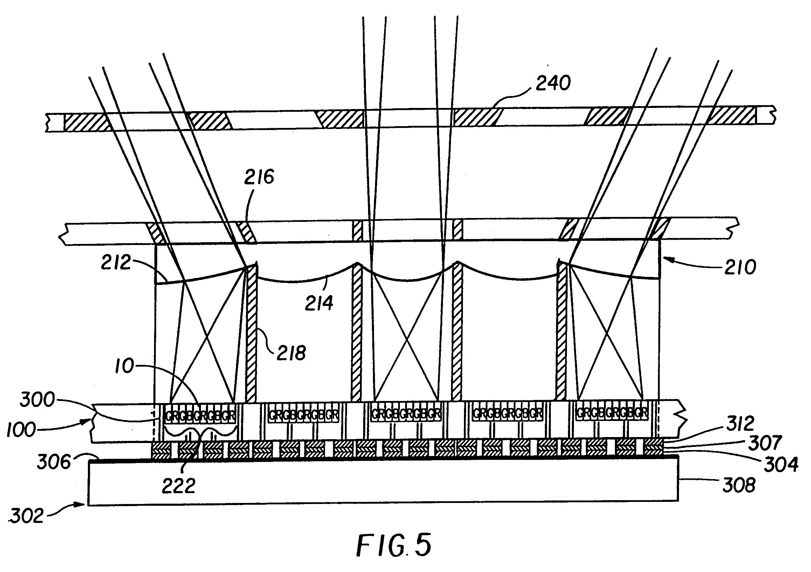

Other forms of making electrical connection between the metalized pads 312 and the emissive pixels 304 may be used, for example, in the embodiment of the invention shown in Figs. 4, 4A, and 5 low temperature eutectic bonding is used. Eutectic solder 307 is printed onto the metalized pads 312 and onto the back surface of the emissive pixels 304 using a silk-screening process. The electrical contact takes place when the two printed surfaces are pressed together with a uniform pressure per unit area at a slightly elevated temperature.

In an alternate embodiment an organic LED (type of display 302) can be formed on the back of the photosensor array 100 by using a lift off process (similar to the process described on pages 535-538 of Chapter 15 in "Silicon Processing for the VLSI Era" by Stanley Wolf, Ph.D and Richard N. Tauber, Ph.D., Lattice Press) to pattern the emissive pixels 304. In this case the metalized and patterned photosensor array 100 is coated with photoresist on the rear surface and lithographically patterned to expose the metal pads 312 for the desired pixel. An indium tin oxide (ITO) coated cover glass is then contacted to the display using either a low temperature eutectic soldering process or an anisotropic conductive film process where temperature and pressure are applied to bond the emissive pixels 304 to the ITO coated glass.

It is also an embodiment of the invention that the pixel display driver 54 can be utilized to drive a reflective LCD type of display through the metalized through-holes 300 in the substrate.

The resolution of the image which is displayed on the back of the camera is not necessarily the same as the resolution of the captured digital image. In some cases it is desirable to use a reduced number of pixels in the display section compared to the number of pixels in the captured image. This is due to the fact the number of pixels in the display unit (320 x 240 pixels) is relatively small compared to the number of pixels present in a high quality, high resolution digital image (640 x 480 or 1000 x 1500 pixels for example).

The use of a reduced number of pixels in the display allows the use of a lower cost display and simplifies the data handling associated with displaying an image when the display is used as a viewfinder. Using a lower resolution display also allows for a more rapid update of the image on the display. A more rapid update eliminates the discontinuous or "jerky" display mode observed in currently produced digital cameras which utilize a display. In the present invention the generation of the reduced size image is accomplished by binning the color pixel intensity values together and taking their mean in a smaller sub array of data used for the display. To accomplish this either the analog voltages or the digital intensity values from multiple adjacent photosensitive pixels are summed together and their mean is taken. The pixel display driver elements 54, which correspond in number to the number of emissive pixels then utilize the input presented from the smaller sub array of data to drive the display.

The amplifiers and signal processing components of the compact image sensor are fabricated using CMOS type integrated circuit fabrication processes involving oxidation, diffusion, ion implantation, patterning with lithography and etching as described in Chapters 7-9, 12-13, and 15-16 of "Silicon Processing for the VLSI Era" by S. Wolf and R. Tauber. The structure of a CMOS MOSFET used in forming amplifiers and logic circuits, and the structure of CCD and photodiode photosensors is described by Sze in Chapters 7, 8, and 13 of "Physics of Semiconductor Devices, Second Edition" (Bell Laboratories, Incorporated, Murray Hill, New Jersey, Wiley-Interscience publication). The circuit configurations for high sensitivity processing and data storage are described later in the specification.

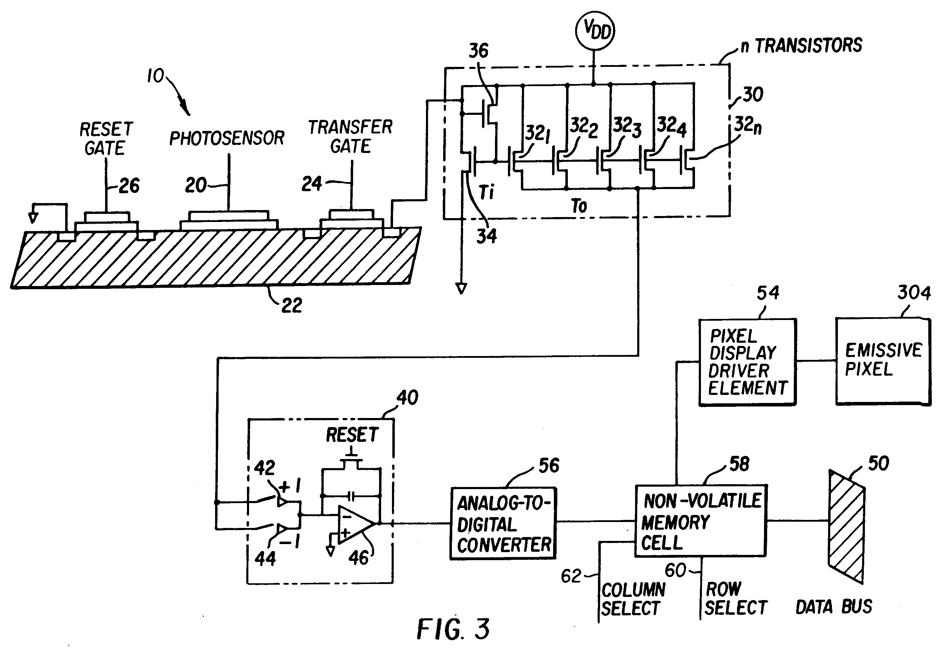

Referring now to Fig. 3, a unit pixel subassembly 10, forms part of the camera's photosensor array 100 (see array of Figs. 1 and 2). The unit pixel subassembly 10 is comprised of a photosensor 20, which may be, for example, a CCD device and/or a photodiode. The output 22 of the photosensor 20 is connected to a transfer gate 24, a reset gate 26, and a multiplying current mirror 30. The transfer gate 24 allows the charge, accumulated by the photosensor 20 during the exposure period, to be transferred to the multiplying current mirror 30 at the desired time. When closed, the reset gate 26 allows for the emptying of the photosensor's 20 accumulated charge from the previously completed exposure. In an embodiment including a mechanical shutter, the reset gate 26 is opened and closed when the camera's mechanical shutter is closed. The output 22 from the photosensor 20 is then integrated for a time equivalent to the previous exposure time so as to cancel dark current and noise. This cancellation occurs within a correlated double sampling circuit (CDS) 40. The integrated signal from the CDS circuit 40 is digitized by an analog-to-digital converter 56 and the resulting digital value is stored in a non-volatile memory 58 which may be a SRAM memory. The digital value can be output to the main data bus 50 by accessing the unit pixel subassembly(s) through row and column address decoders, 60 and 62, respectively. The image data may be stored at site and/or downloaded after each capture. The photosensor array 100 is then ready for exposure to a new image.

The output of the current mirror 30 can be a multiple of the current produced by the photosensor 20. The current multiplying effect is traditionally accomplished either by connecting the bases or gates of the transistors $32_1$ through $32_n$ in parallel with each other or by making the emitter (or source) areas larger by an integral multiple of the emitter area of an input side transistor 34. Current mirrors of this type operate on the principle that the emitter base voltage (or the gate source voltage) for all the transistors on the output side of the current mirror are the same so that each of the collector (drain) currents is the same, and therefore the sum of the currents from the output side $T_o$ is an integral multiple of either the number of transistors in the output side or the ratio of the emitter areas. This current multiplication is represented mathematically as follows:

$$I_{out} = n * I_{in}$$

where
$\quad$ n = number of transistors on the output side "$T_o$" of the current mirror, or

$$n = A_{out} / A_{in} = \text{the ratio of emitter areas}$$

With detailed analysis it can be shown that output current is not as simple as the above equation and is more accurately represented by

$$I_{out} = n * \left(I_{in} / (1 + \beta)\right)$$

where
$\quad$ $\beta$ = transistor current gain (typically between 50 and 200 for bipolar transistors).

In another embodiment of the multiplying current mirror 30 a transistor 36 can be added to the input side $T_i$ of the multiplying current mirror 30 to drive the bases (or gates) of the output side $T_o$ of the multiplying current mirror 30 and thereby reduce the effects of leakage current. This is known to reduce the non-ideality of the above equation to

$$I_{out} = n * \left( I_{in} \, / \left( 1 + \beta^2 \right) \right)$$

The output of the multiplying current mirror 30 is switched between two current amplifiers, amplifiers 42 and 44, with gains of +1 and - 1, respectively. When the photosensor 20 is receiving incident light its amplified current is switched through the +1 gain of amplifier 42 into an integrating amplifier 46 for a given amount of time and then after the shutter is closed the current is integrated through the -1 gain of amplifier 44 for an equal amount of time. This operation is known as dual slope, correlated double sampling, and it eliminates the effects of dark current and KTC noise. It differs from dual sample CDS in that the signal is switched through two different amplifiers depending on whether the signal represents the image data or the background data wherever dual time CDS uses the same amplification chain. It is another embodiment of the current invention to utilize dual sample CDS for noise reduction. Correlated double sampling reduces Johnson noise, flicker noise, and 1/f noise. A similar effect can be achieved by integrating the current from an opaquely masked photosensor through the - 1 gain of amplifier 44. Using an opaquely masked photosensor adjacent to the active photosensor 20 allows the correlated double sampling technique to be implemented in parallel and decreases readout time. The integration of the outputs of the current amplifiers 42 and 44 occurs simultaneously, thus eliminating the need to wait for two integration periods to have output data. However, since separate photosensors are used, small differences in dark current and noise can arise between them.

By utilizing a multiplying current mirror to increase the photocurrent generated at each photosite the effective sensitivity of the photosensor array is increased. Prior art photosensitive arrays (such as CCD arrays) require the use of lenses with very high numerical apertures (low F/#'s, typically on the order of F/1.8 to F/4.0) which are more difficult to align, harder to keep in focus and in general cost more than lower F/# objective lenses. For an array optic camera with a field of view which varies as a function of radial position in the photosensitive array, the use of a photosensor unit cell with increased sensitivity will allow for the use of higher F/# optics (lower numerical aperture) where the definition of lens F/# is given by F/# = Focal Length/Lens Diameter.

The use of the multiplying current mirror in conjunction with the above memory and lenslet array allows for the decrease of the distance between the photosensor sites. However, larger distances between photosensor sites allows for the incorporation of more memory cells. Therefore there is a trade off between the multiplying factor associated with the multiplying current mirror and the number of images that can be stored in the compact imaging array. It is also an embodiment of the invention that the photogenerated charge of the photosensor can be stored after being multiplied by a multiplying current mirror.

The integrated signal from the photosensors 20 is then digitized by an analog-to-digital converter (ADC) circuit 56. The output of the ADC is stored in the memory cell 58. In one embodiment of the invention there is only one memory cell at each unit pixel subassembly site, it is also possible to locate multiple memory cells at each site which allows for the storage of multiple images on the photosensor array 100. This essentially allows the compact photosensor array to act as an optic array camera 200, complete with a lenslet array 210 and an emissive display 302 (see Fig. 5).

The digital intensity data is accessed by strobing the memory cells 58 via row 60 and column 62 address decoders, in order to send data to the data bus 50. The incorporation of the row and column address decoder lines allows for addressing of subsections of the photosensitive array for more rapid image readout in a specific area of interest in the image.

The pixel display driver 54 takes digital data from the non-volatile memory cell 58 and provides a voltage to an emissive pixel 304 that is proportional to the desired intensity in the captured scene. The emissive pixel 304 is part of a display formed as a matrix of emissive pixels 304. This configuration eliminates the need for clocking all of the digital image data out of the image capture sensor, providing it to a display driver circuit, and using row column addressing to generate the scene intensity at the emissive pixel, therefore, it is more compact and efficient.

It is an additional embodiment of the invention that the analog voltage generated at the correlated double sampling circuit 40 can be directly input to the pixel display driver 54 for fastest display or a simpler electronic configuration.

It is another embodiment to achieve the beneficial effects of the invention while utilizing a circuit which integrates the photogenerated charge on a simple floating diffusion node.

In the remaining space between the photosensors voltage amplifiers are formed which allow the display's emissive pixels to be driven from the unit pixel subassembly 10. Incorporating a display increases the utility of the digital camera by allowing the immediate review of images which have been captured in order to determine if the scene is to be kept or discarded. It also allows for the display of images captured earlier for viewing by others.

Another embodiment of the invention is shown in Fig. 4. The lenslet array 210 is formed with the array of achromatized refractive/diffractive lenslets 212 or refractive lenslets which are centered over photosensor sub arrays 222 formed into the photosensor array 100 (shown more clearly in Fig. 5). To be observed in Fig. 4 is that the center of the mechanical optical axis 214 of each lenslet 212 is displaced relative to the fixed sensor-to-sensor distance as a function of its radial distance from the optical axis of the central lenslet. The circular lines 215 appearing around the mechanical optical axis 214 of each lenslet 212 are topographical lines indicating changes in height of the lenslet's surface. An opaque mask 216 fills the areas between the lenslets 212 to prevent light from reaching the photosensor array 100. The lenslet array 210 depicted in Fig. 4 represents only a small portion of an array that will be used in an actual camera. In an actual implementation approximately 150 X 100 lenslets are used to form the lenslet array 210. The photosensor sub array 222 is formed of an array of unit pixel subassemblies 10. Other configurations of the lenslets may be used such as forming the outer periphery of each lenslet as a square, hexagon, or circle, without detracting from the invention.

Each photosensor sub array 222 has associated therewith a multiplying current mirror 30, a correlated double sampling circuit 40, an analog-to-digital converter 56, a sub array photosensor inverter 48, a non-volatile memory cell 58, and a pixel display driver 54. Each photosensor sub array 222 is ultimately attached to a data bus 50 which can output digital image data in response to signals from a row address decoder 60 and a column address decoder 62. Additionally, an emissive pixel display 302 is connected to the compact digital camera as previously described.

Referring now to Fig. 5, the lenslet array 210 is positioned over the photosensor array 100 and the photosensor sub array 222 that correspond in number to at least the number of lenslets used to form the lenslet array 210. In a three color environment up to one third of the sub array of photosensors 222 would be provided with a given color filter (red, green, or blue). The lenslet array 210 is maintained a distance apart from the surfaces of the photosensor sub array 222 by spacers 218 that may also serve the function of being baffles. The opaque masks 216 on the lenslet array 210 combined with a field stop aperture plate 240 limits the field of view of any particular photosensor sub array 222 so that it does not overlap the field of view of it neighbors by a large amount. The field stop aperture plate 240 is positioned approximately 0.5 mm to 3.0 mm from the surface of the lenslet array 210. The field stop aperture plate 240 may be a layer of clear glass having a photoresist mask pattern formed on one of it's surfaces.

The center of the apertures in the aperture plate 240 are aligned to the center of the field of view of a corresponding lenslet. The spacing of the centers increases as a function of each lenslet's radial position radially from the center of the lenslet array causing the aperture plate to be slightly larger than the associated lens array. The combination of the opaque masks 216 with the aperture plate 240 and a given lenslet focal length determines the field of view for a photosensor sub array 222. The lenslet array 210 can be formed of etched quartz, injection molded plastic, or an epoxy replica on a glass substrate.

The lenslets 212, combined with the appropriate field stop aperture plate 240, form images of a small segment of the field of view on each photosensor sub array 222. By forming the lenslets 212 with decentrations of the mechanical optical axis 214 which increase radially across the CCD array, the incident angle which the axial ray makes with the surface normal to the photosensor array will increase as a function of the radial position of the sub array with respect to the center of the photosensor array 100. Therefore, by appropriately adjusting the decenters of each lenslet, each photosensor sub array will view a different segment of the scene to be captured. The sub images from each photosensor sub array are digitally inverted and stitched with the other sub images to form a composite image. Therefore, the present inventive digital camera can be extremely compact and flat. This camera can work in black and white or in color if color filters are used on an appropriate number of photosensors in the photosensor sub array.

Although the lenslet array can operate at low F/#'s (F/2.0) it is advantageous to minimize lenslet diameter (Increasing F/#) so as to minimize the space between lenslets and therefore the image sensor's overall dimensions. This may be accomplished if one incorporates circuitry to amplify the resulting signal from the photosensor. In addition, since the image at each photosensor sub array is inverted with respect to the other sub arrays, means for inverting the image at the sub array are incorporated in one embodiment. This means will consist of mapping the data from one photosensor to a memory location corresponding to a photosensor at a point which is a mirror image of the object reflected about the center of the sub array. It is also an embodiment of the invention to have the sub array images inverted by external circuitry or by means of digital image processing. By utilizing a multiplying current mirror to increase the photocurrent generated at each photosensor the lenslet diameter can be decreased.

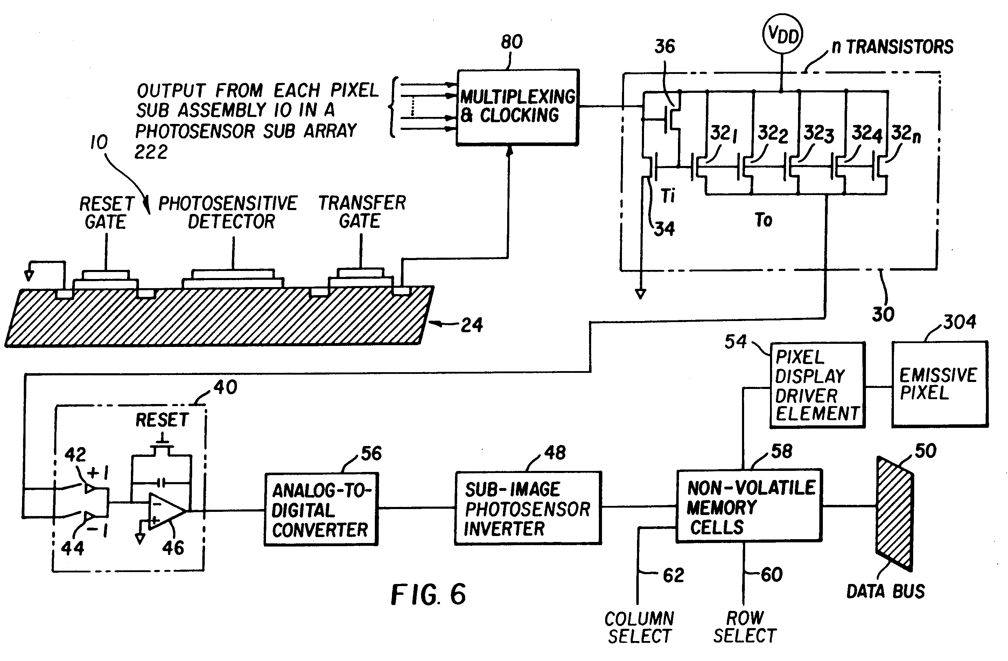

Referring now to Fig. 6, a multiplexing and clocking circuit 80 samples, in turn, the output from each pixel subassembly 10 in an associated photosensor sub array 222, and passes the output 22 to multiplying current mirror 30. The photosensor current from the multiplying current mirror 30 is integrated by the CDS circuit 40 and then digitized by the analog-to-digital converter 56. The sub array photosensor inverter 48 takes data from a given photosensor and maps it to a memory location where an equivalent inverted photosensor would lie. This allows the resulting sub images from each sub array of photosensors to be stitched together to form a larger composite image. The invention utilizes digital image capture and processing to eliminate the need for an additional array of relay lenslets to invert the sub images formed by each objective lenslet 212. It also eliminates the need for a third array of field lenses which may be utilized to maintain illumination uniformity across the lenslet's field of view.

The output of the analog-to-digital converter 56 is stored in the memory cells 58 after inversion by the sub array photosensor Inverter 48. It is also possible to assign a group of memory cells to each photosensor sub array 222. This would allow the compact photosensor array 210 to act as a digital camera.

The digital intensity data is accessed by strobing the memory cells 58 via row and column address decoder lines 60 and 62, respectively, in order to send data to the data bus 50. The incorporation of the row and column address decoder allows for the addressing of subsections of the photosensor array 100 for more rapid image readout in a specific area of interest in the image Display data from the non-volatile memory 58 is used to generate a voltage which is driven through the metalization in the through-holes 300 to the emissive pixels 304 to form an image of the data stored in memory on the display 302. As discussed earlier the display 302 is comprised of a series of emissive pixels 304 coated onto a layer of electrically grounded indium tin oxide 306 on a glass substrate 308.

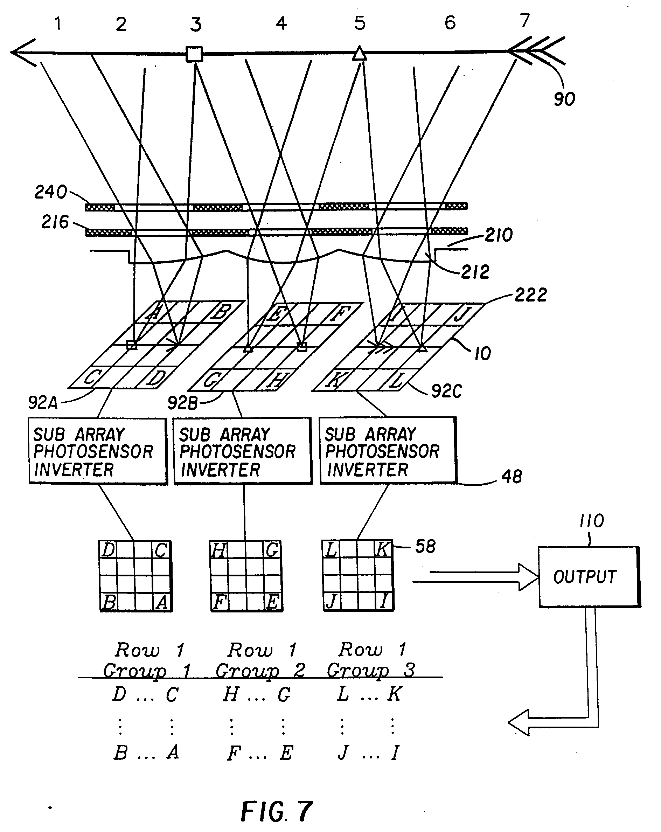

Referring now to Fig. 7, an object 90 (arrow) is imaged onto photosensor sub arrays 222. Each lenslet 212 views a different segment of the field of view. As a result, the segment 1-3 of the arrow forms an inverted image 92A that impinges on its respective photosensor sub array 222. Likewise the segment 3-5 of the arrow 90 forms an inverted image 92B that impinges on its respective photosensor sub array 222. The same holds true for the segment 5-7 forming the inverted image 92C. Noted in the drawing is that the images 92A through 92C do not form, from left to right, a continuous image of the arrow 90. More specifically, note that point 1 is adjacent point 5 and that point 3 is adjacent point 7 at the surfaces of the photosensor sub array 222. That is, if the sub-images of the arrow 90 were simply stitched together, the overall mosaic (composite) image would be scrambled and unusable.

To arrange the pixel image data in proper order the charges from the matrix of photosensors 20 In each photosensor sub array 222 are first clocked out and multiplexed through their respective current multiplying circuit, correlated double sampling circuitry, and digitised by the ADC. The digital data from a pixel, representing an image, in each photosensor sub array 222 is positionally inverted with respect to the center of each photosensor sub array 222. Therefore, a sub array photosensor inverter 48 is needed to take the pixel data from a pixel located at point A and to store it in a memory cell 58 which is inverted with respect to the central pixel of the photosensor sub array. For example, pixel A would be stored in the memory 58 at a location corresponding to D. The overall mosaic composite image is then built up for use by an output device 110 which is for this instance the emissive display 302. A computer and/or a digital printer may also be used to form the output image.

In summary, overall image pixel data is generated from the photosensor sub array by digitally stitching the sub-images back together to form a composite image. This is accomplished by taking the row data from each sub array in turn and adding it to the row data for the next sub array until the end of the array is reached. Then the address for the next column of row data, at the farthest point on the array, is used to start building the next row of image data by adding the row data from the next sub array until the end of the line of sub arrays is reached, at which point the address pointer moves to the beginning of the next column. In some embodiments it may be useful to have some image overlap from one sub array to the next. This would require the address decoding technique to be able to determine which location in a sub array row is to be used as the first pixel from that row.

The invention has been described with reference to preferred embodiments, however, it will be appreciated that variations and modifications can be effected by a person of ordinary skill in the art without departing from the scope of the invention.

**PARTS LIST**

| | |
|---|---|
| 10 | unit pixel subassembly |
| 20 | photosensor |
| 22 | output |
| 24 | transfer gate |
| 26 | reset gate |
| 30 | multiplying current mirror |
| $32_1$ -$32_n$ | transistors |
| 34 | input side transistor |
| 36 | transistor |
| 40 | correlated double sampling circuit (CDS) |
| 42 | current amplifiers |
| 44 | current amplifiers |
| 46 | integrating amplifier |
| 48 | sub array photosensor inverter |
| 50 | data bus |
| 54 | pixel display driver element |
| 56 | analog-to-digital converter |
| 58 | memory |
| 60 | row address decoder line |

| 62 | column address decoder line |
|---|---|
| 80 | multiplexing and clocking circuit |
| 90 | object (arrow) |
| 100 | photosensor array |
| 200 | compact image capture and display device (digital camera) |
| 210 | lenslet array |
| 212 | lenslets |
| 213 | optical axis |
| 214 | mechanical optical axis |
| 215 | circular lines |
| 216 | opaque mask |
| 217 | photosensor sites |
| 218 | spacers |
| 222 | photosensor sub array |
| 300 | through-holes |
| 302 | display |
| 304 | emissive pixel |
| 305 | anisotropically conductive film |
| 306 | transparent indium tin oxide layer |
| 307 | eutectic solder |
| 308 | glass layer |
| 310A | traces |
| 310B | traces |
| 312 | metal pad |
| 314 | conductive metal spheres |

**Claims**

1. A compact image capture and display device, comprising:

   an array of spaced apart radiation sensors for providing output signals that are a function of the amount of incident radiation from an image onto each radiation sensor;
   array electronics dispersed in the spaces between the spaced apart radiation sensors for receiving and processing the provided output signals to facilitate image capture;
   a lens array positioned so as to focus the radiation of an image to be captured onto said radiation sensors; and
   a display connected in close proximity to said array electronics to receive the processed output signals from said array electronics and to display the image captured by said radiation sensors.

2. The compact image capture and display device according to Claim 1 and further comprising:

   a planar support member having said array of radiation sensors formed on one surface and said display formed on an opposite surface and having connections passing through said planar support member to connect said display to said array electronics.

3. The compact image capture and display device according to Claim 2 wherein said support member is a semiconductor material having said array of radiation sensors formed integrally therein.

4. The compact image capture and display device according to Claim 1 wherein said display is an array of LEDs.

5. The compact image capture and display device according to Claim 1 wherein said display is an array of organic LEDs.

6. An image capture and display device comprising:

   an array of spaced apart groups of radiation sensors for providing output signals that are a function of the color of incident radiation from an image onto each radiation sensor;
   array electronics dispersed in the spaces between the spaced apart groups of radiation sensors for receiving and processing the provided output signals;

a lens array positioned so as to focus the wavelengths of radiation from an image to be captured onto associated radiation sensors in each of the groups of said radiation sensors such that each radiation sensor in a group provides an output signal that is stored as a function of its colors; and

a display means for receiving the processed output signals from said array electronics and for visually displaying the images captured onto the radiation sensors.

7. The image capture and display device according to Claim 6 and further comprising:

a planar support member having said array of radiation sensors formed on one surface and said display formed on an opposite surface and having connections passing through said planar support member to connect said display to said array electronics.

8. The image capture and display device according to Claim 7 wherein said support member is a semiconductor material having said array of radiation sensors formed integrally therein.

9. A compact image capture and display device, comprising:

a photosensor array of current generating photosensors each in combination with an associated multiplying current mirror located adjacent thereto and comprised of one input transistor and at least two output transistors where the generated photocurrent from each photosensor is multiplied by an integer equal to the number of output transistors in the associated multiplying current mirror with the output of the current mirror being forwarded to a digitizing and memory means located adjacent to an associated current mirror for storage, a display connected to display the digitized output of the current mirrors.

10. A compact digital camera, comprising:

a lenslet array comprised of a plurality of lenslets, each lenslet having a decentration corresponding to its radial position in the lenslet array so that the axial ray of each lenslet views a different segment of a total field of view;
a color photosensor array comprised of a plurality of sub arrays of photosensors wherein each sub array of photosensors is comprised of sets of Red, Green, and Blue color sensitive photosensors, each sub array of photosensors being positioned along the axial ray of a respective lenslet;
a field limiting baffle comprised of at least one aperture plate where the center of the apertures are positioned to lie along the axial ray of a respective lenslet; and
a color display for displaying the colors sensed said color photosensor array.

FIG. 1

FIG. 1A

FIG. 2

FIG. 2A

FIG. 3

EP 0 893 915 A2

FIG. 4

FIG. 4A

EP 0 893 915 A2

FIG.5

FIG. 6

OUTPUT FROM EACH PIXEL
SUB ASSEMBLY 10 IN A
PHOTOSENSOR SUB ARRAY
222

RESET GATE

PHOTOSENSITIVE DETECTOR

TRANSFER GATE

MULTIPLEXING & CLOCKING

n TRANSISTORS

RESET

ANALOG-TO-DIGITAL CONVERTER

SUB-IMAGE PHOTOSENSOR INVERTER

PIXEL DISPLAY DRIVER ELEMENT

EMISSIVE PIXEL

NON-VOLATILE MEMORY CELLS

DATA BUS

COLUMN SELECT

ROW SELECT

EP 0 893 915 A2

FIG. 7